(19)

**Europäisches Patentamt**
**European Patent Office**
**Office européen des brevets**

(11) **EP 3 043 189 B1**

(12) **EUROPEAN PATENT SPECIFICATION**

(45) Date of publication and mention
of the grant of the patent:
**23.08.2017 Bulletin 2017/34**

(51) Int Cl.:
*G01R 33/032* *(2006.01)* *G01R 15/24* *(2006.01)*
*G01R 15/14* *(2006.01)*

(21) Application number: **13799624.5**

(22) Date of filing: **04.09.2013**

(86) International application number:
**PCT/ES2013/070621**

(87) International publication number:
**WO 2015/033001 (12.03.2015 Gazette 2015/10)**

(54) **OPTICAL SYSTEM FOR IDENTIFYING FAULTS IN MIXED POWER TRANSMISSION LINES**

OPTISCHES SYSTEM ZUR IDENTIFIKATION VON STÖRUNGEN IN GEMISCHTEN
HOCHSPANNUNGSÜBERTRAGUNGSLEITUNGEN

SYSTÈME OPTIQUE POUR L'IDENTIFICATION DE DÉFAUTS DANS DES LIGNES MIXTES DE
TRANSPORT ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.07.2016 Bulletin 2016/28**

(73) Proprietor: **Arteche Centro de Tecnologia, A.I.E.
48100 Munguia (Vizcaya) (ES)**

(72) Inventors:
 • **GALLASTEGI URIARTE, Andoni**
 **E-48100 Munguia (Vizcaya) (ES)**
 • **SÁNCHEZ LEKUE, Aritz**
 **E-48100 Munguia (Vizcaya) (ES)**

(74) Representative: **Balder IP Law, S.L.
Paseo de la Castellana 93
5a planta
28046 Madrid (ES)**

(56) References cited:
 EP-A1- 2 407 792   CN-B- 101 275 834
 US-A1- 2002 122 183   US-A1- 2004 189 997
 US-A1- 2011 051 145   US-A1- 2012 187 937
 US-B1- 6 611 337   US-B2- 7 683 795

 • CHAN M F ET AL: "On-line fault location system
 for overhead power transmission lines using
 passive quasi-distributed fibre optic sensing",
 ADVANCES IN POWER SYSTEM CONTROL,
 OPERATION AND MANAGEMENT, 1993. APSC
 OM-93., 2ND INTERNATIONAL CONFERENCE ON
 HONG KONG, LONDON, UK,IEE, UK, 1 January
 1993 (1993-01-01), pages 243-251, XP006514256,
 ISBN: 978-0-85296-569-6
 • BOHNERT K ET AL: "Optical fiber sensors for the
 electric power industry", OPTICS AND LASERS
 IN ENGINEERING, ELSEVIER, AMSTERDAM, NL,
 vol. 43, no. 3-5, 1 March 2005 (2005-03-01), pages
 511-526, XP027724049, ISSN: 0143-8166
 [retrieved on 2005-03-01]
 • KEZUNOVIC M ET AL: "The 21st century
 substation design: Vision of the future", 2010
 IREP SYMPOSIUM BULK POWER SYSTEM
 DYNAMICS AND CONTROL - VIII (IREP 2010) :
 [BUZIOS], RIO DE JANEIRO, BRAZIL, 1 - 6
 AUGUST 2010, IEEE, PISCATAWAY, NJ, USA, 1
 August 2010 (2010-08-01), pages 1-8,
 XP031746836, ISBN: 978-1-4244-7466-0
 • PETERSEN A E: "PORTABLE OPTICAL AC- AND
 PROPOSED DC-CURRENT SENSOR FOR HIGH
 VOLTAGE APPLICATIONS", IEEE
 TRANSACTIONS ON POWER DELIVERY, IEEE
 SERVICE CENTER, NEW YORK, NY, US, vol. 10,
 no. 2, 1 April 1995 (1995-04-01), pages 595-599,
 XP000539084, ISSN: 0885-8977, DOI:
 10.1109/61.400873

**EP 3 043 189 B1**

**(Cont. next page)**

- FROSIO G ET AL: "RECIPROCAL REFLECTION INTERFEROMETER FOR A FIBER-OPTIC FARADAY CURRENT SENSOR", APPLIED OPTICS, OPTICAL SOCIETY OF AMERICA, WASHINGTON, DC; US, vol. 33, no. 25, 1 September 1994 (1994-09-01), pages 6111-6122, XP000473296, ISSN: 0003-6935, DOI: 10.1364/AO.33.006111
- BRIAN CULSHAW ET AL: "Fiber-Optic Sensing: A Historical Perspective", JOURNAL OF LIGHTWAVE TECHNOLOGY, IEEE SERVICE CENTER, NEW YORK, NY, US, vol. 26, no. 9, 1 May 2008 (2008-05-01), pages 1064-1078, XP011216263, ISSN: 0733-8724
- PITT G D ET AL: "Optical-fibre sensors", IEE PROCEEDINGS,, vol. 132, no. 4, 1 August 1985 (1985-08-01), pages 214-248, XP001622025,

## Description

## TECHNICAL FIELD

The invention relates to the field of fault identification in electrical power transmission lines and, in particular, to the identification of faults in mixed lines, in other words, those that combine overhead sections (also called *aerial sections*) with sections in cable.

## BACKGROUND OF THE INVENTION

In overhead power distribution lines, temporary faults (temporary short-circuits) tend to occur, in other words, faults that occur due to unforeseeable causes (because the branch of a tree falls onto the line, for example) and disappear after a while. All distribution lines have protection systems, generally a current transformer and a circuit breaker (or *switch*), in such a way that when the transformer detects the fault, (the overcurrent produced by the short-circuit), it opens the circuit breaker leaving the line out of service. These protection systems are found in substations. Many of these faults are temporary, meaning that the protection system itself automatically re-engages (closes the circuit breaker) immediately after having opened it. If the fault persists, a new re-engagement can be attempted, for example one minute later. If the fault persists, the fault can be interpreted as being foreseeably permanent, meaning that maintenance operatives must be dispatched to solve it. This is the usual functioning when a fault occurs on an overhead line. In summary, in conventional electrical power grids, re-engagement is one of the main functions incorporated into the protections for overhead high voltage lines, since it makes it possible to continue with an overhead line in service following a temporary fault occurring on it.

Sometimes, and with increasing frequency, electrical power distribution lines comprise some non-overhead section, in other words, some section in cable (the power transmission line is clad with insulation). The most frequent examples (although not the only ones) of electrical power distribution sections in cable are underground sections (for example, in proximity to an airport or urban zones or for environmental reasons) and underwater sections. In this case, if the fault has occurred in the underground section, re-engagement may not be desirable (for example, because the fault may be due to operatives or machines working, in which case it could put the operatives' lives at risk). In other words, if the section is underground, the re-engagement function is overridden, because faults in underground portions are considered to be permanent.

The problem lies in the fact that the fault may have occurred in the overhead section of the line, but in this case automatic re-engagement cannot be performed in the event the fault is in the underground section (in general, the section in cable). The problem therefore arises in mixed lines (having overhead sections and cable sections), where it is very important to be able to determine in which section or at which point the fault occurs. An error in detection, declaring the temporary fault to be in the underground section when in reality the fault is in the overhead section, unnecessarily deprives the power system from continuing to operate with the mixed line in service. Therefore, one objective of electrical power grid providers is to identify or distinguish the cable section of the mixed line where the fault occurs, in order to be able to use re-engagement in all the existing overhead sections and to increase availability.

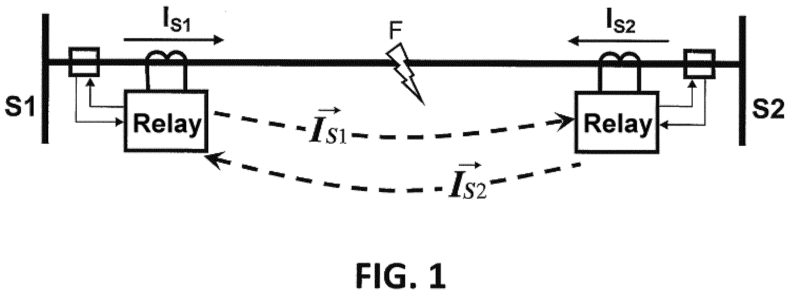

One solution to this problem involves providing the cable section with a line differential protection system. Differential protection is widely implemented as a unitary protection in transport grids (lines, transformers, busbars) and certain distribution systems. It is based on the calculation of the difference in current that "enters" and "leaves" the protected element. This difference is practically zero in normal conditions and with external faults, whereas for internal faults it is other than zero. This entails installing a current transformer before the start of the cable section (underground, for example) and another current transformer at the exit of the cable section and the corresponding protection equipment provided with synchronisation and communications in order to compare the measurements of both transformers. If the currents are not the same, it means that a fault has occurred in the underground section. The conventional application of line differential protection follows the scheme represented in a simplified manner in figure 1. As may be seen from figure 1, line differential protections are installed on both ends of the line, with communication between them, to know the current measured by each one of them. Based on the local current measurement and the measurement received through communication from the remote end, each protection calculates the differential current and determines how to act according to an operating characteristic.

However, this solution has several drawbacks. On the one hand, a hut is required associated to each current transformer in order to house the necessary electrical and electronic equipment, and the electrical power supply. Installing each hut requires a portion of land and putting a security fence in place.

To overcome these drawbacks, it is possible to use optical current sensors (OCS) and to transmit the measurements using optical fiber. In this way, one of the two huts can be eliminated and the measurement of the other sensor can be carried out by the optical fiber (up to 20 km approximately). It is also possible to eliminate the second hut and to carry the data from the OCS to the nearest substation using optical fiber.

So as not to have to lay several kilometres of optical fiber, it is possible to use the so-called guard cable that many electrical power lines carry. In addition to the three electrical cables corresponding to the Three-Phase Symmetrical Grid lines, the lines carry a cable that runs along the top part of the electricity pylons, which is used as a lightning arrestor. This cable has a hollow steel core and inside can carry a series of optical fiber cables (known as OPGW, *Optical Ground Wire*). Therefore, some of these cables can be used to transmit signals from the OCS. The problem is that each line differential protection system measures the current of the three phases at both ends of the cable, and needs two optical fibers per measurement point. Since six optical current sensors OCS are necessary, 12 fibers are needed, which have a very high cost.

Therefore the problem is considered as to how to reduce the number of optical fiber cables required to transmit the signals from the OCS. This can be achieved by means of the optical time-division multiplexing technique, as described, for example, in patent documents US2004/0189997A1, US6611337 and WO2009/103126A1 By using this technique, the optical sensors take specific current measurements at a same instant in each phase, and by means of a multiplexed network with delays, a series of pulses that are out of phase in time is obtained. In this way, it is possible to know the information with a reduced number of optical fiber cables (the number of optical fibers required may be one, two, three, four, six or twelve).

On the other hand, the usual optical sensors installed on the line, further to adding complexity to the system, have a high cost. To avoid this, a flexible sensor can be used, which is a sensitive optical fiber cable which is wound around the conductor, thereby constituting the optical sensor, as explained below. The remote current measurement using passive optical sensors helps to overcome the problems associated to electromagnetic current transformers, such as nonlinearities and saturations, in addition to the problems associated to their complex installation in places where it is not desirable to modify the existing installation.

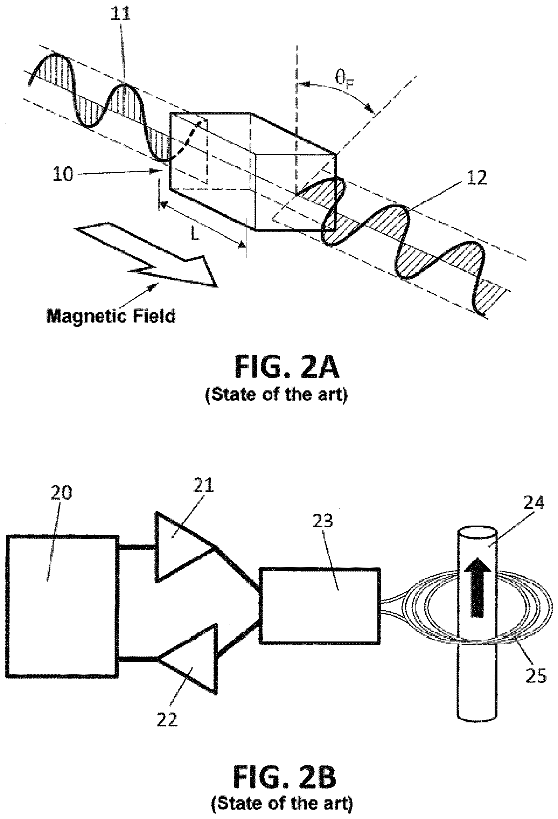

These sensors are based on the Faraday effect, whose functioning principle consists of measuring the change in the state of light polarisation in a magneto-optical material, when the latter is subjected to a magnetic field. As illustrated in figure 2A, the state of polarisation of the light when it passes through a magneto-optical material 10 subjected to a magnetic field H sustains a variation proportional to the current in the same direction of light propagation (incident beam 11 and transmitted light 12). When said magneto-optical material 10 surrounds a conductor, the measurement of the change in state of polarisation throughout the entire material indicates the current that is circulating through said conductor. Figure 2B shows the beginning of a Faraday effect optical current sensor, made up of a sensor fiber 25 which surrounds a conductor 24, a source of light 21 which emits an optical signal, an optical circuit 23 to which the two ends of the sensor fiber 25 are connected, a detector 22 and a signal processing block 20.

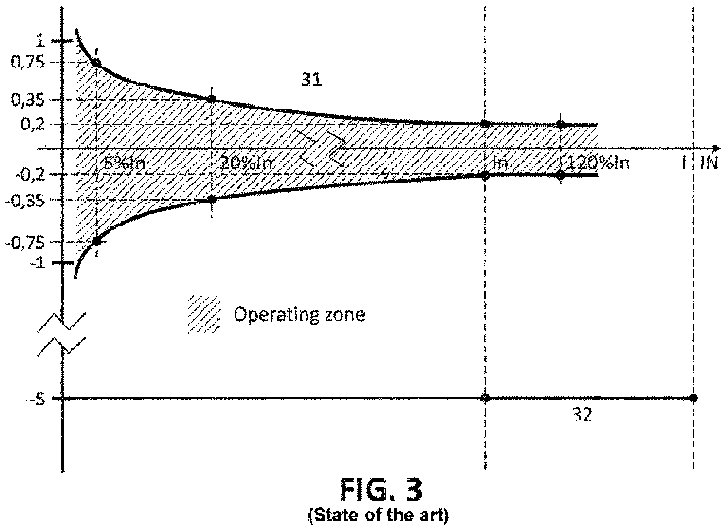

The sensor's response to the magnetic field is totally linear, and therefore all sources of error implicit in electromagnetic circuits disappear. In applications related to the protection of electrical power lines the disappearance of all nonlinearities associated to the phenomena of ferromagnetic core saturation is particularly important. As an example of application of said linearity, the graph of figure 3 shows the precision of an optical current measurement transformer. As may be seen, as the current increases the shaded zone of transformer operation narrows. This allows the same unit to comply with the measurement and protection classes, with the particular feature of having measurement precision (the curve represents the measurement precision limit 31) in the protection range (the figure illustrates the conventional protection precision limit 32).

This type of solution is used for example in international patent application WO2011/031945A1, which describes a line differential protection system based on two current sensors, one main one or master, and another secondary one or slave. Each of the two current sensors takes measurements of the current that passes through a conductor at two different points (where the two sensors are located). The measurements taken are sent to an electronics box through a fiber optic link. This sensor system has the drawback of being electronic, in other words, it needs an electrical power supply to be carried to the master sensor.

## DESCRIPTION OF THE INVENTION

The present invention tries to resolve the drawbacks mentioned above by means of an optical differential protection system for the remote identification of faults on mixed electrical power transmission lines (in other words, having at least one section of the line in cable, for example underground or underwater), which does not require carrying a power supply to any of the sensors.

In a first aspect of the invention, a differential optical system is provided for the remote identification of faults on a mixed electrical power transmission line delimited by a first electrical substation and a second electrical substation, wherein said mixed line comprises at least one section of overhead line (aerial line) and one section of cabled line. The system comprises at least one first optical current sensor situated at a first point of the mixed line, which comprises: a sensor fiber designed to surround an electrical power transmission cable whose intensity is to be monitored, and one passive optical circuit; and at least one second current measurement device independent of the first optical current sensor, situated at a second point of the mixed line, configured to take measurements of the current intensity that circulates through an electrical transmission cable. The sensor fiber is made up of a section of sensitive optical fiber connected at one end to the passive optical circuit and of one section of insensitive optical fiber (or non-sensitive optical fiber) connected at one end to the passive optical circuit, and the free end of the sensitive optical fiber is connected by means of a splice to the free end of the insensitive optical fiber, in such a way that the section of sensitive optical fiber acts as the element for measuring the current intensity to be monitored and the section of insensitive optical fiber acts as the means of transmission of the measurements taken towards the passive optical circuit. The differential optical system comprises additionally a fault discrimination device configured to process the current measurements coming from the at least one first optical current sensor and from the at least one second current measurement device and to detect faults in the mixed electrical power transmission line. This device is connected to the optical current sensor by means of single-mode optical fiber configured for sending an optical signal and returning the measurements taken by the sensor fiber to the fault discrimination device.

In a possible embodiment, if the mixed line is an intermediate mixed line, the at least one second current measurement device independent of the first optical current sensor is a second optical current sensor, which comprises: one sensor fiber which can be disposed surrounding an electrical power transmission cable whose intensity is to be monitored, and one passive optical circuit.

In another possible embodiment, if the mixed line is a terminal mixed line, the at least one second current measurement device independent of the first optical current sensor can be a current transformer. In this case, the fault discrimination device is preferably situated in the electrical substation nearest to the second current measurement device.

Preferably, the passive optical circuit comprises a first bidirectional coupler; three second bidirectional couplers connected to the first bidirectional coupler; and two third bidirectional couplers connected respectively to one of the ports of each second bidirectional coupler; and where the sensor fiber is connected to the first bidirectional coupler forming a Sagnac loop, in such a way that in response to a pulse of light sent to the sensor fiber, the latter sends a plurality of current measurements taken in each phase and at several different instances in time.

Preferably, the sensor fiber comprises a high birefringence sensitive optical fiber. And more preferably, the high birefringence sensitive optical fiber has been twisted during its manufacture.

In a preferred embodiment, the connection of one end of the sensitive optical fiber to the passive optical circuit, and the connection of one end of the insensitive optical fiber to the passive optical circuit, as well as the splice between the free ends of the sensitive optical fiber and the insensitive optical fiber, are performed at the factory.

Preferably, the optical current sensor is designed to be installed around an insulated high voltage cable.

Preferably, the fault discrimination device is designed to be installed in a substation of the electrical power grid.

At least at the first point of the mixed line, there is preferably a plurality of optical current sensors each one made up of one coiled sensor fiber configured to surround an electrical power transmission cable whose intensity is to be monitored, and one passive optical circuit; and one junction box to which the plurality of optical current sensors are connected using dedicated fiber optic cable. The fault discrimination device is connected to the junction box using single-mode optical fiber. Preferably, the junction box is designed to be installed on a pylon that carries the electrical power transmission line.

Preferably, multiplexing means are included configured to multiplex each output fiber of each passive optical circuit into a single multiplexed signal connected to the junction box.

In a possible embodiment, the fault discrimination device comprises a source of light configured to emit a pulse of light towards the sensor fiber; a plurality of photodetectors configured to receive the responses coming from the sensor fiber; and means for processing the responses and detecting faults in the electrical power transmission line. Preferably, the fault discrimination device comprises also a plurality of duplex ports of single-mode optical fiber.

The benefits of the invention will become apparent in the light of the description that follows.

## BRIEF DESCRIPTION OF THE DRAWINGS

To complement the description and with a view to contributing towards a better understanding of the characteristics of the invention, according to an example of a practical embodiment thereof, a set of drawings is attached as an integral part of the description, which by way of illustration and not limitation, represent the following:

Figure 1 is an outline of a conventional application of line differential protection.
Figure 2A represents the principle on which the Faraday effect is based.
Figure 2B shows an outline of a Faraday effect optical current sensor.
Figure 3 illustrates an example of the current measurement precisions obtainable with optical technology.
Figure 4A shows an outline of the passive optical circuit of the current sensor according to one embodiment of the invention.
Figure 4B shows a transversal (left) and longitudinal (right) section of the sensor fiber according to a possible embodiment of the present invention.
Figure 4C shows a section of a cable of the flexible sensor according to one implementation of the invention.
Figures 5A and 5B show the configuration of the sensor fiber according to a possible implementation of the invention.
Figures 6A and 6B show two embodiments that include a set of three flexible current sensors and their connection, according to a possible implementation of the invention.

Figure 7 illustrates a block diagram of a fault discrimination terminal according to a possible embodiment of the invention.

Figures 8A to 8D illustrate embodiments of the differential fault detection system of the present invention. Figure 8A shows an outline of the differential fault detection system. Figure 8B shows an outline of the mixed line in detail. Figure 8C shows a detail of an intermediate mixed line. Figure 8D shows a detail of a terminal mixed line.

Figure 9 shows the operating characteristic of the line differential protection.

## DESCRIPTION OF A MODE OF EMBODIMENT OF THE INVENTION

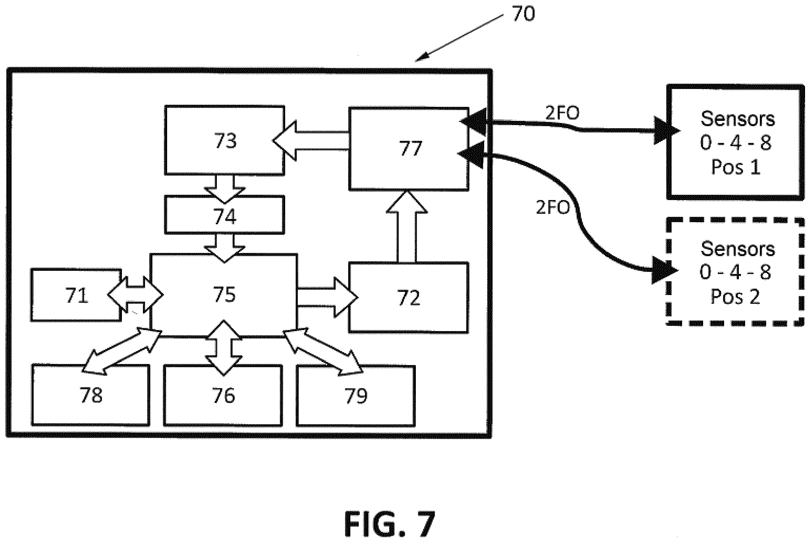

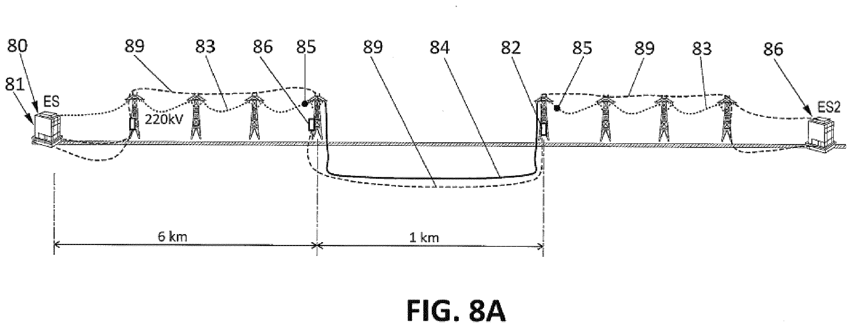

Figure 8A shows an outline of the differential system of fault identification in mixed transmission lines of the present invention. A part of the electrical power grid is illustrated with various overhead (aerial) electrical power distribution lines (specifically, eight pylons are shown). The pylons (towers) carry high voltage lines overhead 83. Between the fourth and the fifth illustrated pylons there is an underground section 84 (where the high voltage line is insulated from the outside by means of a cable). At one of the ends of the figure a fault discrimination terminal 80 is shown, which is described in more detail in relation to figure 7, installed in a substation ES. The figure also shows the single-mode optical fiber 89 that runs throughout the installation end to end (between the two substations 81 86).

The remote optical current sensors are designed to be installed around an insulated high voltage cable. Preferably, the optical current sensors 85 are installed on each one of the two pylons that limit the underground section 84. The system is made up of several optical current sensors (for example, six), several dedicated optical fibers, preferably single-mode optical fiber 89 (for example standard OPGW single-mode optical fiber) and one fault detection and discrimination terminal. Preferably, three optical current sensors 85 are installed on each one of the two towers that limit the underground section 84 (one per phase). The sensors are grouped preferably into threes so as to minimise the number of dedicated optical fibers to be used and are connected in a connections box or junction box 82. In a possible embodiment, the multiplexing of the sensors is performed in this box.

In the example of figure 8A the underground section measures approximately 1 km and the distance between the fault discrimination terminal 80 and the first pylon that delimits the underground section is of approximately 6 km. This data is by way of an example and may change in the various real implementations, depending on the disposition of the lines, pylons, etc.

Each set of three optical current sensors 85 installed on each pylon that delimits the underground section 84 is made up of totally passive optical sensors. These two sets of passive optical sensors allow differential optical measurements to be taken for the remote identification of faults in the underground section. Unlike the systems for taking differential measurements based on conventional optical sensors, the one of the invention, due to the fact that it is totally passive, does not require an electrical power supply to be taken to any of the sensors. In other words, the sensor(s) located at one point of the mixed line is (are) independent of the sensor(s) located at another point of the mixed line.

As explained further below, each set of three sensors 85 performs the corresponding measurements in a totally passive manner, and sends them to the fault discrimination terminal 80. The sensors 85 of each pylon that delimits the underground section 84 are independent of each other, unlike, for example, the master sensor and the slave sensor of the differential optical system of WO2011/031945A1.

The mixed line may be intermediate or terminal. It is intermediate when the section of cable (underground, underwater, etc.) runs between two overhead sections. In this case, the fault discrimination terminal 80 is installed in a remote substation ES in respect to any of the two pylons that delimit the section of cable. The mixed line is terminal when the section of cable is followed by an overhead section at one end only. In this case, the fault discrimination terminal 80 is installed in a remote substation ES at the place (or nearby) that delimits the start of the section of cable (for example, underground).

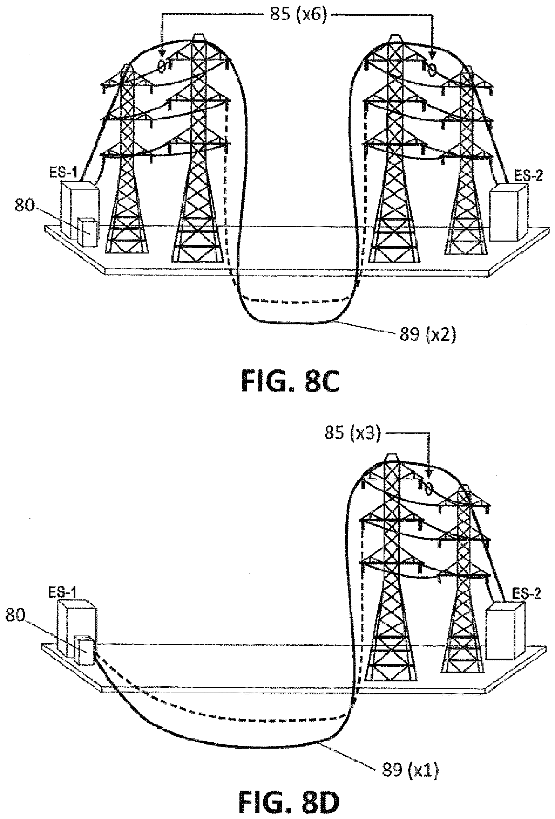

In terminal mixed lines, at the end of the section of cable where the fault discrimination terminal 80 is found it is not necessary to use optical current sensors 85 for taking measurements, instead the electrical current measurement can be taken locally, for example using a current transformer. The measurement is taken locally (as opposed to remotely) because the measurement device (for example, current transformer) is located at the end of the section of cabled line where the fault discrimination device 80 is also located. The latter is located preferably in the electricity substation (in figure 8D, referred to as ES-1) nearest to said current measurement device. In this case, the measurement device (for example, current transformer) is also located in that electricity substation (ES-1).

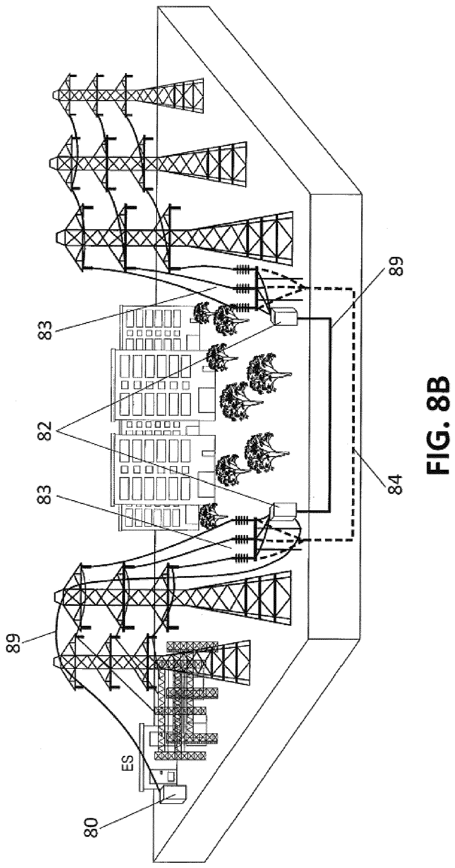

Figure 8B shows in detail an outline of an intermediate mixed line. The figure shows the two pylons that delimit the underground section, the high voltage lines that run overhead 83 and underground 84, the single-mode optical fiber 89 (for example, OPGW), the fault discrimination terminal 80 and the junction boxes 82.

Figure 8C shows a detail of an intermediate mixed line, wherein 6 optical current sensors and two pairs of single-mode fiber 89 (for example OPGW) are used.

Figure 8D shows a detail of a terminal mixed line, wherein 3 optical current sensors are used at the end of the remote underground section (in other words, on a pylon of the overhead section) in respect to the substation that has the fault discrimination terminal 80 and a single-mode fiber pair 89 (for example OPGW) installed. Note that in this case it is not necessary to use optical current sensors at the end where the fault discrimination terminal 80 is located, and that instead the measurements at this end can be taken in a conventional manner, for example by means of a current transformer. In this case, the differential measurement is made up of electrical current measurements taken remotely using the optical current sensors and electrical current measurements taken locally without having to use the passive optical network.

The differential measurement of the electrical current is based on taking measurements of said current at two different points of the section under inspection and comparing (in the fault discrimination device) the measurements between the two points. The remote measurements are sent to said fault discrimination device through optical fiber. The two points at which the measurements are taken may be several kilometres apart. If a fault occurs between the two sensitive devices, the currents that pass through the two measurement points are different and that difference is detected in the fault discrimination device.

The current sensors 85 are installed preferably below the terminal bushings, embracing both the conductor as well as the bushing connection to earth. The junction box 86 and the sensor fiber (of the current sensors 85) as well as the single-mode interconnection fiber (for example, OPGW) are secured to the metallic structure of the frame using standardised supports. No alteration of the frame is required. The optical circuit box is secured trying to minimise the distance between it and the measurement point. This distance is preferably less than 1 m. The sensor fiber of the current sensor 85 is wound around the circuit to be measured (cable and earth return of the bushing). The end of the sensor fiber is secured in the optical circuit box using hardware incorporated thereto. To avoid mechanical fatigue on the sensor, once wound it is secured with staples supplied to the metal openwork structure. One single hose with 2 single-mode fibers is run up to the junction box of the OPGW. The 2 fibers from the current sensors are fused to two fibers of the OPGW. After checking the losses of the optical link one proceeds with connecting in the substation said fibers to the corresponding optical channel of the fault discrimination terminal or module. On the frame corresponding to the other end of the underground cable the procedure is the same.

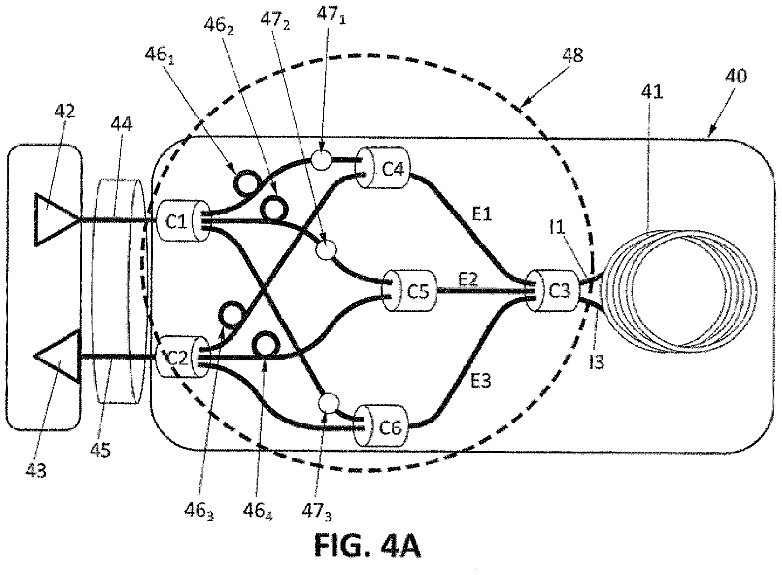

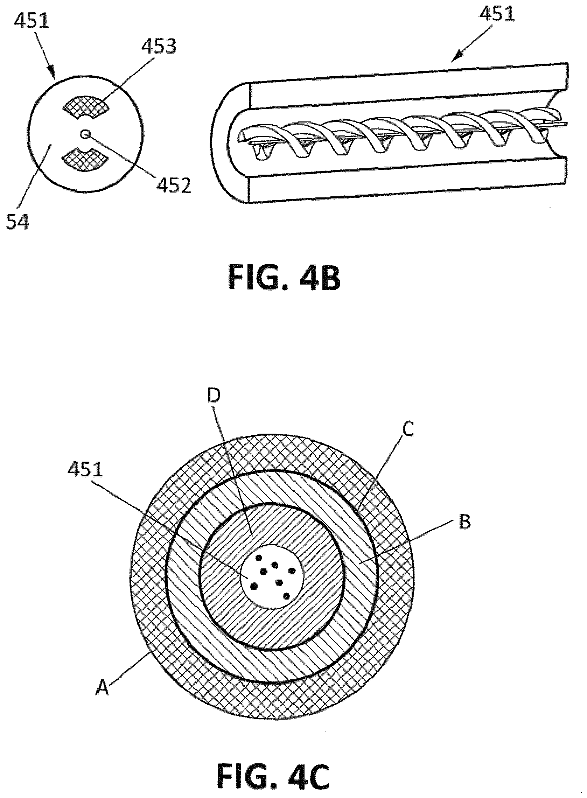

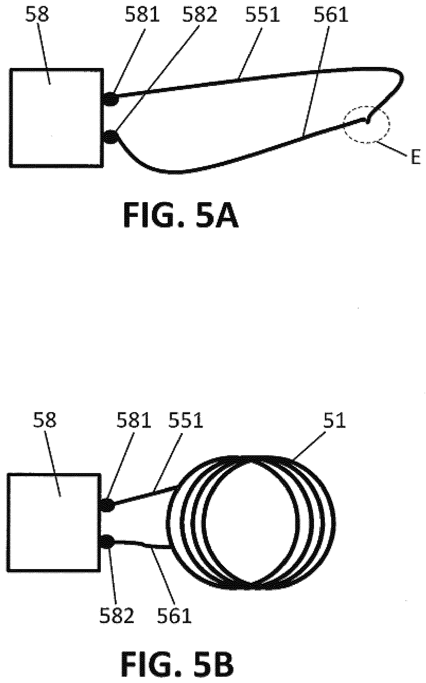

Figure 4A shows a preferred embodiment of the passive optical circuit of the current sensor 40, used to take remote optical measurements of the electrical voltage in the mixed section. The current sensor 40 is totally passive, in other words, it does not require an electrical power supply. This makes it possible to perform remote current measurements, eliminating any type of infrastructure at the measurement point. The current sensor 40 comprises a Sagnac interferometer closed by a bidirectional coupler C3. The interferometer has three external ports E1 E2 E3 and three internal ones, two of which close the Sagnac loop I1 I3. The coupler C3 is therefore a 3x3 coupler. This eliminates the need to use modulators or other elements that require control electronics. Note that although in figure 4 two internal ports I1 I3 are shown in the C3 coupler, there is a third not illustrated port which is not used. The Sagnac loop is completed with a sensor fiber 41 which is illustrated in detail in figure 5. The coupler C3 is connected in turn to the bidirectional couplers C4 C5 C6 through ports E1 E2 E3 respectively. Couplers C4 C5 C6 are of the 2 x 2 type, in other words, are capable of coupling two inputs to two outputs in a bidirectional manner. In the implementation of the figure, one of the outputs is left unconnected, with the couplers acting in 2 x 1 mode in a bidirectional manner. At the same time, couplers C4 C5 C6 are connected to bidirectional couplers C1 C2 which in this configuration are of type 1 x 3, in other words, couple one input to three outputs and vice versa.

Hence, the output of the optical source 42, after travelling through a standard single-mode fiber (for example OPGW) 44, reaches the coupler C1 and from there is immediately coupled (without intended delay) to coupler C6 and after a delay imposed by the delay loop $46_1$ to coupler C4, and following another delay imposed by the delay loop $46_2$ to coupler C5. The two delays $46_1$ $46_2$ are different to each other. In the three cases between couplers C1 and C4, C1 and C5 and C1 and C6 a depolariser $47_1$ $47_2$ $47_3$ is included. The output of coupler C4 is carried immediately (without intended delay) to coupler C3. The same happens with the outputs of couplers C5 and C6. Each pulse of light that enters C3 produces 3 output pulses, for each one of its ports E1 E2 E3. As 3 pulses are introduced, 9 output pulses are obtained. The delays are calculated taking into account the duration of the pulse of light, and in such a way that the nine outputs do not overlap, and make up a train of 9 pulses for each measurement of one phase.

On the return path, the output signals of coupler C3 are directed immediately (without intended delay) to couplers C4 C5 C6. From coupler C6 the signal is coupled immediately to coupler C2. From coupler C5 the signal is coupled to coupler C2 after a delay imposed by delay loop $46_4$. From coupler C4 the signal is coupled to coupler C2 following a delay imposed by delay loop $46_3$. From coupler C2 the nine signals received are sent to detector 43 through a standard single-mode optical fiber (for example OPGW) 45. Reference number 48 refers to the passive optical circuit that is made up of the optical current sensor 40 (also made up of the sensor fiber 41, which is explained further below). All the fiber of the passive optical circuit 48 is preferably single-mode fiber.

By using this technique, the optical sensors take specific current intensity measurements at the same instant in each phase, in such a way that a series of pulses that are out of phase in time are obtained. These measurements are multiplexed and return to the control system (not illustrated in figure 4A). The functioning is as follows: the control system delivers a pulse of light (through emitter 42) to the sensor fiber 41 and this latter returns nine pulses (three measurements in three instances). The current intensity value is coded in the relationship between these pulses, in other words, relative, not absolute values are measured. There is one sensor fiber for each phase. In this way, it is possible to know the information with a reduced number of optical fiber cables.

Each sensor fiber corresponds to one sensor. A sensor is installed on each phase. The measurement of each phase generates 9 pulses of light. Therefore for three phases there are 27 pulses of light. And the measurements of the current in the 3 phases and at the two ends of the cable represent a total of 54 pulses. The simplest scheme would entail, in the absence of multiplexing:

1. The pulse that is emitted in the emitter 42 and that reaches C1 is divided into 3, which at different moments (due to the delays 46-1 and 46-2) enter E1, E2, and E3.
2. First it enters E3 and generates 3 pulses. In this simple scheme, 46-3 and 46-4 and coupler C2 are eliminated for simplicity. In this way we need 3 receivers like 43, which fibers will reach from C4, C5, and C6.

In this scheme, the return signals would not be multiplexed, meaning that 4 fibers would be necessary per sensor: 1 fiber for the pulse to reach from 42, and 3 fibers for the return of the 3 outputs of 3x3 coupler C3.

This would entail using 4 fibers per sensor, times 6 sensors needed to measure the 6 phases (3 phases at both ends of the cable), which result in a total of 24 fibers.

As of this point the possibilities of temporary multiplexing begin. The concept of multiplexing is simple: for 2 pulses that occur (totally overlap) at the same instance, a delay is introduced on one so that they no longer overlap in time. Now it is possible, by means of a coupler, for the two pulses to travel through the same fiber without interfering with one another.

In this way, different configurations may be encountered, by adding delays and couplers to the circuit:

a. 2 fibers for each sensor -> total 12 fibers
b. 3 fiber for every 3 sensors -> total 4 fibers
c. 2 fibers for all 6 sensors - > total 2 fibers

And the number of combinations is greater, since it is also possible to opt for having a single source of light 42 for all 6 sensors, up to 6 sources of light.

Figure 4B shows one possible transversal section (left) and one longitudinal section (right) of the sensor fiber 451 used in an embodiment of the present invention. Note that the transversal section is illustrated by way of an example, and may adopt other different forms. As a magneto-optical material, the sensor comprises a high birefringence optical fiber 451 which has been twisted during manufacture. The traditional alternative was to use monolithic crystals. In order to allow current primaries to pass through, these crystals had to be built in large dimensions, with the associated problems of fragility and limited flexibility for different sensor designs. For this reason, this optical fiber is used as a sensor element, given that it provides great versatility in the design of electrical current sensors.

In the detail of figure 4B, it can be seen how the sensor fiber 451 has a core 452 and a coating or cladding 454 and a stress zone 453. Figure 4C shows a section of a cable (set of the fiber or fibers, together with their cladding and other protective elements) of the flexible sensor according to one implementation of the invention. The black dots represent a plurality of sensitive optical fibers 451, which have an approximate diameter of 0.125 mm. Cable is the name given to the set of fiber or fibers, together with their cladding and other protective elements. The outer cladding A covers a set of reinforced glass fibers B, which in turn cover a central tube with gel D. Between the central tube with gel D and the reinforced glass fibers B there is a breakaway wire C. Inside the central tube with gel D are the sensor optical fibers 451.

The proposed solution is outlined in figures 5A and 5B. To overcome these drawbacks, the proposal is to use sensitive optical fiber 551 connected at the factory to one of the ends 581 of the passive optical circuit 58. By being connected at the factory all the problems associated to the difficulty of an operative having to connect it in the field at considerable height and on a high voltage pylon are avoided. The length of this sensitive optical fiber is chosen according to the need in each case: it is possible to manufacture current sensors of different sensitivities by merely varying the number of twists of the sensor fiber. The other end 582 of the passive optical circuit 58 is connected, also at the factory, to an insensitive optical fiber 561. This prevents having to make delicate connections that operatives may not be prepared for in the field and in conditions of difficult access. Finally, the respective free ends of the sensitive optical fiber and the insensitive optical fiber are spliced together (reference E in figure 5A), also at the factory. The double cable made up of the two fibers is wound enveloping the conductor, thereby constituting the optical transformer (see figure 5B). The sensitive optical fiber part is the one that measures the change in the state of light polarisation in the magneto-optical material when this latter is subjected to a magnetic field. Given that the magneto-optical material (the section of sensitive fiber) surrounds the conductor, the measurement in the change of state of polarisation throughout the entire material indicates the current that is circulating through said conductor.

Once the sensitive fiber has been wound, the spliced end E which closes the loop made up of the two fibers 551 561 is secured (not with an electrical connection, instead just mechanically secured) next to a point 581 to close the last coil. End E can be secured to the passive optical circuit 58 or to any other thing, as long as the sensitive fiber does not unwind and the coil remains closed.

As may be observed, the sensors based on optical fiber have great mechanical flexibility. Therefore, it is possible to manufacture flexible sensors.

Thanks to the fact that the sensor element is optical fiber 451 551, it is possible to manufacture current sensors 40 with different sensitivities by just varying the number of turns of the sensor fiber.

This allows a unique design to be achieved, totally passive, wherein common optical components for telecommunications fiber are used working preferably with a wavelength of 1550 nm or 1310 nm (second and first transmission windows, respectively).

Returning to figure 4A, as stated, the connection of the sensor 40 to the electro-optics 42 43 is performed using single-mode optical fiber 44 45, which may be connectorised, and which can reach distances of more than 10 km, with the only limitation being the one given with the balance of losses.

Thanks to all of the above it is possible to build a remote current measurement system, adaptable to existing installations and totally free of maintenance.

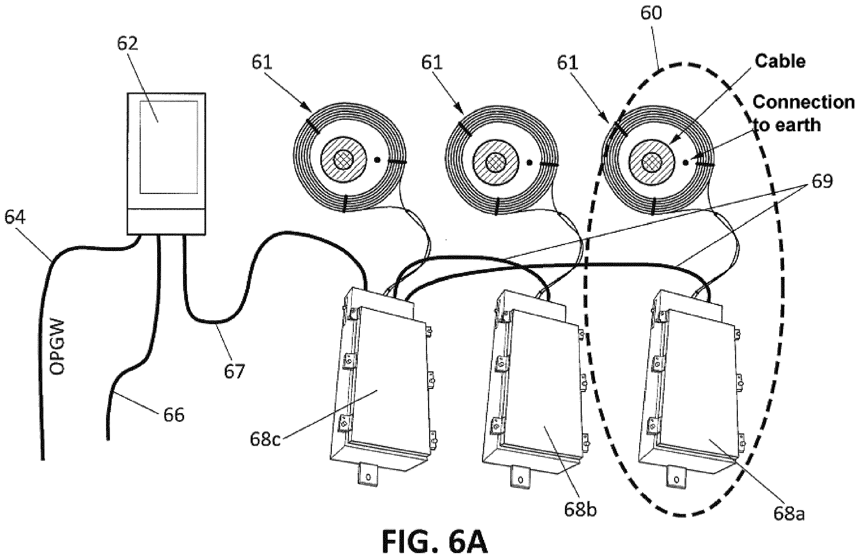

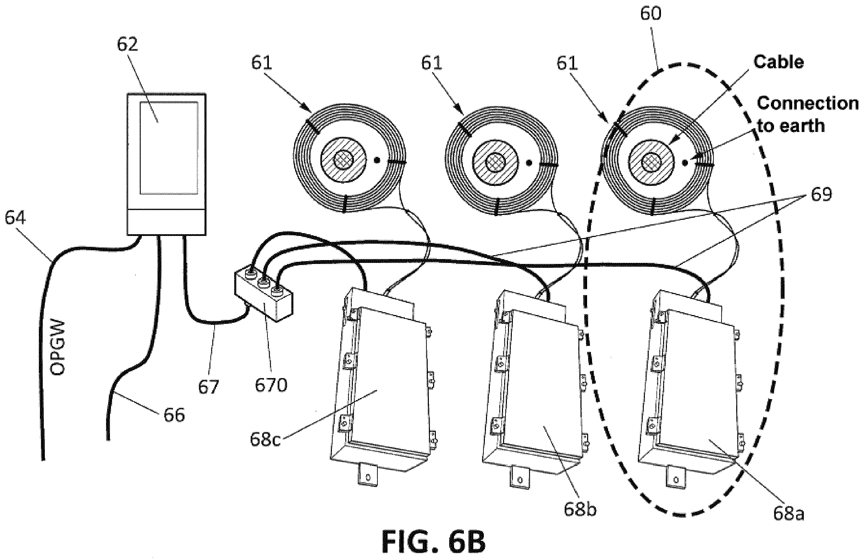

Preferably, for the application of fault detection in mixed sections (such as those that include, for example, underground or underwater sections), the sensors 40 are grouped in threes in order to minimise the number of dedicated optical fibers to be used by the system. This is illustrated in figures 6A and 6B, which show a particular example of implementation of the invention, with a set of three flexible current sensors and their connection. In both figures three optical sensors 60 are shown, each one of which is made up of one sensor fiber 61 which act as a magneto-optical element surrounding the cable whose current intensity is to be monitored. Each sensor 60 also has its own associated totally passive optical circuit 68a 68b 68c, which must be installed as close as possible to the measurement points. Each set of three sensors is connected to a junction box 62. This junction box 62 is the one already existing on the transition post from overhead line to cable (for example, underground or underwater). In the overhead line, the optical fibers run through OPGW 64. In the cable section the fibers run through a cable that is buried next to the electrical conductors. This is why a junction box 62 is necessary, in order to pass from one type of cable to another. The system of the invention takes advantage of this circumstance in order to be able to access the optical fibers that run from one substation to another in a simple manner. Therefore, the junction box 62 receives three cables (each one of which has several optical fibers): one is the single-mode fiber cable OPGW 64 which runs next to the overhead line up to the substation; another one 66 is the one that runs next to the underground cable towards the other substation, which is the continuation of the single-mode OPGW fiber (all the fibers are fused); the third cable 67 is the one coming from the system of sensors, which is normally composed of 1 or 2 or 6 fibers. In the junction box 62 it is necessary to "break" the fusions of the fibers that run from one substation to another and that are intended for use, and to fuse them to the fibers of the measurement system of the invention. The choice to use the fibers that come from the OPGW or from the underground part depends only on which substation the sensors need to be connected to. The optical circuits 68a 68b 68c can be connected with one another at the factory, so during installation only splicing to the fibers of OPGW 64 must be carried out by using 2 dedicated optical fibers every set of three sensors. By the implementation of figure 6A, the optical circuit 68c has internally (not shown in the figure) time-division multiplexing equipment based on delays and couplers, which multiplex the pulses coming from the three sensor fibers 61. The multiplexed output 67 is connected to the junction box 62. In the alternative implementation of figure 6B, there is time-division multiplexing equipment 670 based on delays and couplers, which receives the output 69 from each one of the three optical circuits 68a 68b 68c and multiplexes that information into a single output 67. Reference number 69 represents the double single-mode optical fiber of the passive optical sensor 60 (fibers 44 and 45 in figure 4) which comes from each optical circuit 68a 68b 68c.

The flexible current sensor 40 60 is a totally passive element, composed of elements of optical fiber. The sensor itself is a dielectric hose or dielectric cable (see figure 4C) connected to the optical circuits 68 at one end. Said hose has to be wound around the conductor whose circulating current is required to be measured. The final end of the sensor is secured for example in the cable securing zone of the junction box 62. This configuration of the sensor 40 60 allows for its configuration without having to perform any type of manipulation of the fibers. This installation of the equipments can be performed by personnel qualified for OPGW installations. The interconnection of the different sensors is performed preferably using dielectric cables of optical fiber 66 67 with anti-rodent protection.

On the other hand, in order to measure the current, electronic equipment is required for controlling the source of light and processing the results of the interferometry in order to obtain the measurement of the current circulating inside the sensor. This equipment is a fault discrimination terminal (cited in relation to figures 8A-8D) and is the only element of the system that is installed in the substation. One single device is capable of controlling several sensors. In a preferred embodiment, one single device controls up to 6 sensors. This equipment processes the currents coming from all sensors, and without the need for external communications elements, implements the differential algorithms that make it possible to detect faults in the protection zone comprised between the sensors.

Preferably, each fault discrimination terminal has as many duplex ports of single-mode optical fiber as may be necessary in order to control six sensors, more preferably with SC/APC connectors, in such a way that each port is capable of controlling up to 3 current sensors (connected to a junction box 62, which is the one that is connected by means of single-mode optical fiber to the fault discrimination terminal); 1 Ethernet port for local configuration and tele-management. The equipment is adjusted by means of a web page, meaning that the only tool necessary for starting it up and managing it is a web browser; several programmable potential free contacts (for example, four); and one series port.

Figure 7 shows a block diagram of a possible implementation of the fault discrimination terminal 70, which includes a source of light 72 and photodetectors 73, both connected to an optical interface 77 with two duplex ports, configured to receive the inputs of the OPGW single-mode optical fibers, one analogue/digital converter 74 for handling the photodetected signals, one digital signal processor 71, one FPGA 75, local IP interface (for example Ethernet) 78 for local configuration and tele-management, several contacts 76 and one series interface 79.

Next an optimal algorithm for fault detection used by the system of the invention is described. When there is a measurement of the current intensity at the terminals of the element to be protected, in this case the section of line in cable, an optimal algorithm is that of differential protection.

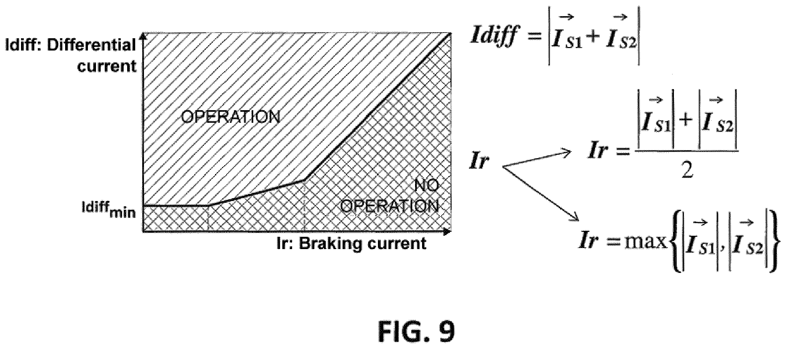

The conventional application of line differential protection follows the scheme represented in a simplified manner in figure 1. As mentioned previously, based on the local current intensity measurement and the one received via communication from the remote end (in this case terminal mixed line), or based on the current intensity measurements received via communication from one first remote end and from one second remote end (in the case of the intermediate mixed line) each protection calculates the differential current and determines how it acts according to an operating characteristic, such as the one shown in figure 9, where $I_{diff}$ represents the differential current and $I_r$ represents the braking current, and where:

$$I_{diff} = \left| \overrightarrow{I_{S1}} + \overrightarrow{I_{S2}} \right|$$

$$I_r = \frac{\left| \overrightarrow{I_{S1}} \right| + \left| \overrightarrow{I_{S2}} \right|}{2}$$

$$I_r = max\left\{ \left| \overrightarrow{I_{S1}} \right|, \left| \overrightarrow{I_{S2}} \right| \right\}$$

Ir can be calculated according to either of the two formulae above, or to any other, at the discretion of the person implementing the algorithm.

The proposed system allows the fault to be detected based on the line differential in the underground section, which is the most effective and efficient option for fault discrimination. The characteristics inherent to this technology based on the optical system of current measurement makes it possible to measure from the substation the current of a position kilometres away from it, with a totally passive system constructed exclusively with optical fiber. All of this is achieved with a drastic reduction of the system's components, given that an auxiliary power supply is not necessary at the measurement points, or the installation of communication equipment. One single unit of equipment receives the measurements from both ends of the line.

The system of the invention provides, through the fault discrimination terminal, the following information: information on a fault in the underground section (or underwater or others) for blocking the re-engagement contained in the primary protection and in the secondary protection in the event of an anomaly of the primary one; information on an anomaly in the fault identification system for transmission lines with underground (or underwater or other) sections to a local control system, cabled; information on an anomaly to primary and secondary protections.

The fault discrimination terminal does not act for faults external to the section in cable (for example, underground). In the event of the fault occurring in the overhead section of the line, the system detects that the fault has been outside the cable section and does not send information to the line protections, with these latter executing re-engagement.

The detection of the fault on the part of the fault discrimination terminal is independent of the type of fault (it must detect all types of faults: single-phase to earth, two-phase, two-phase to earth and three-phase) and of the type of cable screen connections in the underground section.

Furthermore, the equipment installed on the line in order to measure the current intensity are totally passive and do not need any type of maintenance. This makes it possible to consider the equipment installed on the metal frame as structural elements, with maintenance requirements equivalent to those provided to the optical fiber junction boxes. The installation of the sensors on the lines' frames is performed without any type of modification thereto, using standardised and common elements and hardware for OPGW installations. This simplicity makes it possible for the same personnel that perform the connections and splices of the OPGW to be the best suited to install this equipment.

The proposed supervision, measurement and discrimination of faults in the underground section are totally remote, in other words, the protection equipment does not have to be next to the sensors, rather it can be at a distance of kilometres away from them, whenever optical fiber for their connection is available.

As already mentioned, the fault discrimination terminal is the only element of the system that is installed in the substation. It is connected to the sensors situated in the overhead-underground transitions of the transmission line by means of the OPGW of said line and communicates with the protections and also with the control for blocking the re-engagements.

In a specific implementation, by way of an example, based on the scheme of figure 8C, 6 current sensors are installed on the 220kV line, 3 at each end of the cable to be protected. The sensors are of the flexible type, which are wound around the base of the cable's terminal bushings. In the installation it is only necessary to secure the sensors and the 3 optical circuits to the openwork structure of the frame, and to make 2 splices in the junction box. 4 OF of the OPGW are used for the connection of the optical sensors (2 optical fibers for each set of three sensors). The electronics that process the measurements and execute the differential algorithm are installed in the substation on the left end of the figure.

For any person skilled in the field of fault identification in electrical power transmission lines, the benefits of the proposed solution are easy to appreciate. Among them, the fact that all "active" components are located in the substation, meaning that acquisition, installation and maintenance costs are reduced to a minimum. In particular, mini-substations in overhead-underground transition, 2 synchronisation clocks, 2 line differential protections, 2 control and communications positions and 2 power supply systems for auxiliary services that would be necessary if a line differential protection system were implemented on the cable using conventional current intensity transformers, are eliminated. All of the above while maintaining the fault detection based on classical line differential algorithms, thereby providing the system with maximum reliability. The result of the traditional algorithms is even improved by the linear response of the optical sensors to the fault current and by the absence of saturations.

In summary, a technology has been proposed that allows the remote measurement with a flexible sensor having passive optical technology. In other words, to the benefits of the optical measurement (which solves the problems of linearity and saturation) and passive measurement (which allows remote measurement using optical fibers of the OPGW), the flexibility, which allows installation on the cable without modifying the installation, is added.

In this text, the word "comprises" and its variants (such as "comprising", etc.) must not be interpreted in an excluding manner, in other words, they do not exclude the possibility of what is being described including other elements, steps, etc.

At the same time, the invention is not limited to the specific embodiments that have been described and rather also encompasses, for example, variants that may be embodied by a person with ordinary skill in the art (for example, with regard to the choice of materials, dimensions, components, configuration, etc.), within the scope of what is inferred from the claims.

**Claims**

1. A differential optical system for the remote identification of faults on a mixed electrical power transmission line delimited by a first electricity substation and a second electricity substation, wherein said mixed line comprises at least one section of overhead line and one section of cabled line, the differential optical system comprising:

at least one first optical current sensor (40) situated at a first point of said mixed line, comprising: a sensor fiber (41, 51) designed to surround an electrical power transmission cable whose current intensity is to be monitored, and one passive optical circuit (48, 58),
at least one second current measurement device independent of said first optical current sensor (40), situated at a second point of said mixed line, configured to take measurements of the current intensity that circulates through an electrical power transmission cable, and
a fault discrimination device (70, 80) configured to process the current measurements coming from said at least one first optical current sensor (40) and from said at least one second current measurement device, and to detect faults on said mixed electrical power transmission line, the differential optical system being **characterised in that** said sensor fiber (41) is made up of one section of sensitive optical fiber (451, 551) connected at one end (581) to said passive optical circuit (48, 58) and one section of insensitive optical fiber (552) connected at one end (582) to said passive optical circuit (48, 58) and wherein the free end of said sensitive optical fiber (451, 551) is connected by means of a splice (E) to the free end of said insensitive optical fiber (552), in such a way that said section of sensitive optical fiber (451, 551) acts as an element for measuring the current intensity to be monitored and said section of insensitive optical fiber (552) acts as a means of transmission of the measurements taken towards said passive optical circuit (48, 58), and **in that** said device (70, 80) is connected to said optical current sensor (40) by means of single-mode optical fiber (89), wherein said single-mode optical fiber (89) is configured for the sending of an optical signal and the return of the measurements taken by the sensor fiber (41, 51) up to said fault discrimination device (70, 80).

**2.** The system of claim 1, wherein if said mixed line is an intermediate mixed line, said at least one second current measurement device independent of said first optical current sensor (40) is a second optical current sensor, which comprises: a sensor fiber (41, 51) which may be disposed surrounding an electrical power transmission cable whose current intensity is to be monitored, and one passive optical circuit (48, 58).

**3.** The system of claim 1, wherein if said mixed line is a terminal mixed line, said at least one second current measurement device independent of said first optical current sensor (40) is a current transformer.

**4.** The system of claim 3, wherein said fault discrimination device (70, 80) is situated in the electricity substation nearest to said second current measurement device.

**5.** The system of any of the preceding claims, wherein said passive optical circuit (48, 58) comprises one first bidirectional coupler (C3); three second bidirectional couplers (C4, C5, C6) connected to said first bidirectional coupler (C3); and two third bidirectional couplers (C1, C2) connected respectively to one of the ports of each second bidirectional coupler (C4, C5, C6); and wherein said sensor fiber (41, 51) is connected to the first bidirectional coupler (C3) forming a Sagnac loop, in such a way that in response to a pulse of light sent to the sensor fiber (41, 51), the latter sends a plurality of current measurements taken in each phase and at several different instances in time.

**6.** The system of any of the preceding claims, wherein said sensor fiber (41, 51) comprises high birefringence sensitive optical fiber (451, 551).

**7.** The system of claim 6, wherein said high birefringence sensitive optical fiber (451, 551) has been twisted during manufacture.

**8.** The system of any of the preceding claims, wherein said connection of one end of the sensitive optical fiber (451, 551) to the passive optical circuit (581) is made at the factory, said connection of one end of the insensitive optical fiber (552) to the passive optical circuit (582) is made at the factory, and said splice (E) between the free ends of the sensitive optical fiber (451, 551) and the insensitive optical fiber (552) is made at the factory.

**9.** The system of any of the preceding claims, wherein said optical current sensor (40) is designed to be installed around an insulated high voltage cable.

**10.** The system of any of the preceding claims, wherein said fault discrimination device (70, 80) is designed to be installed in a substation of the electrical power grid.

**11.** The system of any of the preceding claims, which comprises in at least said first point of the mixed line, a plurality of optical current sensors (60) each one made up of one sensor fiber (41, 51, 61) coiled and configured to surround an electrical power transmission cable whose current intensity is to be monitored, and one passive optical circuit (48, 58, 68a, 68b, 68c),
and one junction box (62, 82) to which said plurality of optical current sensors (60) are connected by means of dedicated fiber optic cable (67);
wherein said fault discrimination device (70, 80) is connected to said junction box (62, 82) by means of single-mode optical fiber (89).

**12.** The system of claim 11, wherein said junction box (62, 82) is designed to be installed on a pylon for carrying electrical power transmission lines.

**13.** The system of any of claims 11 or 12, which comprises multiplexing means (68c, 670) configured to multiplex each output fiber (69) of each passive optical circuit (68a, 68b, 68c) into a single multiplexed signal (67) connected to said junction box (62).

**14.** The system of any of the preceding claims, wherein said fault discrimination device (70) comprises a source of light (72) configured to emit a pulse of light towards the sensor fiber (41, 51); a plurality of photodetectors (73) configured to receive the responses coming from said sensor fiber (41, 51); and means (74, 71, 75) for processing said responses and detecting faults on the electrical power transmission line.

**15.** The system of claim 14, wherein said fault discrimination device (70) additionally comprises a plurality of duplex ports of single-mode optical fiber (77).

**Patentansprüche**

**1.** Differentielle optisches System für die entfernte Erkennung von Fehlern auf einer gemischten elektrischen Leistimgsübertragungsleitung, die von einer ersten Elektrizitätsumspannstelle und einer zweiten Elektrizitätsumspannstelle begrenzt ist, wobei besagte gemischte Leitung wenigstens einen Abschnitt an Oberleitung und einen Abschnitt an kabelgebundene Leitung umfasst, das differentielle optische System umfassend:

wenigstens einen ersten optischen Stromsensor (40), der sich an einer ersten Stelle besagter gemischter Leitung befindet, umfassend: einer Sensorfaser (41, 51), die ausgestaltet ist, um ein elektrisches Leistungsübertragungskabel zu umgeben, dessen Stromintensität zu überwachen ist, und eine passive optische Schaltung (48, 58),

wenigstens ein zweites Strommessgerät, das von besagtem ersten optischen Stromsensor (40) unabhängig ist, das sich an einer zweiten Stelle besagter gemischter Leitung befindet und das eingerichtet ist, um Messungen der Stromintensität zu nehmen, die durch ein elektrisches Leistungsübertragungskabel zirkuliert, und

ein Fehlerunterscheidungsgerät (70, 80), das eingerichtet ist, um die Strommessungen zu verarbeiten, die von besagtem wenigstens einen ersten optischen Stromsensor (40) und von besagtem wenigstens einen Stromsensor (40) und von besagtem wenigstens einen zweiten Strommessgerät kommen, und um Fehler auf besagter gemischten elektrischen Leistungsübertragungsleitung zu detektieren,

wobei das differentielle optische System **dadurch gekennzeichnet ist, dass** besagte Sensorfaser (41) aus einem Abschnitt an sensitive optischer Faser (451, 551), die an einem Ende (581) mit besagter passiver optischer Schaltung (48, 58) verbunden ist, und einem Abschnitt an nicht-sensitiver optischer Faser (552), die au einem Ende (582) mit besagter passiver optischer Schaltung (48, 58) verbunden ist, ausgebildet ist, und wobei das freie Ende besagter sensitiver optischer Faser (451, 551) mittels eines Spleißes (E) mit dem freie Ende besagter nicht-sensitiver optischer Faser (552) auf solch eine Weise verbunden ist, dass besagter Abschnitt an sensitiver optischer Faser (451, 551) als ein Element zum Messen der Stromintensität wirkt, die zu überwachen ist, und besagter Abschnitt an nicht-sensitiver optischer Faser (552) als ein Mittel zur Übertragung der genommenen Messungen in Richtung besagter passiver optischer Schaltung (48, 58) wirkt,

und dadurch, dass besagtes Gerät (70, 80) mit besagtem optischen Stromsensor (40) mittels monomodaler optischer Faser (89) verbunden ist, wobei besagte monomodale optische Faser (89) eingerichtet ist für das Senden eines optischen Signals und den Rücktransport der Messungen, die von der Sensorfaser (41, 51 genommen wurden, bis zu besagtem Fehlerunterscheidungsgerät (70, 80).

2. System nach Anspruch 1, wobei wenn besagte gemischte Leitung eine dazwischenliegende gemischte Leitung ist, besagtes wenigstens eine zweite Strommessgerät, das von besagtem ersten optischen Stromsensor (40)unabhängig ist, ein zweiter optischer Stromsensor ist, welcher eine Sensorfaser (41, 51), welche ein elektrisches Leistungsübeitragungskabel umgebend angeordnet sein kann, dessen Stromintensität zu überwachen ist, und eine passive optische Schaltung (48, 58) umfasst.

3. System nach Anspruch 1, wobei wenn besagte gemischte Leitung eine endständige gemischte Leitung ist, besagtes wenigstens eine zweite Strommessgerät, das von besagtem erstem optischem Stromsensor (40) unabhängig ist, ein Stromwandler ist.

4. System nach Anspruch 3, wobei besagtes Fehlerunterscheidungsgerät (70, 80) in der Elektrizitätsumspanustelle angeordnet ist, die am nächsten zu besagtem zweiten Strommessgerät ist.

5. System nach einem der vorherigen Ansprüche, wobei besagte passive optische Schaltung (48, 48) einen ersten bidirektionalen Koppler (C3); drei zweite bidirektionale Koppler (C4, C5, C6), die mit besagtem ersten bidirektionalen Koppler (C3) verbunden sind; und zwei dritte Bidirektionale Koppler (C1, C2), die entsprechend mir einem der Anschlüsse von jedeiu zweiten bidirektionalen Koppler (C4, C5, C6) verbunden sind umfasst; und wobei besagte Sensorfaser (41, 51) mit dem ersten bidirektionale Koppler (C3) eine Sagnac-Schleife bildend auf solch einer Weise verbunden ist, dass als Antwort auf einen Lichtpuls, der an die Sensorfaser (41, 51) gesendet wird, die letztere eine Vielzahl an Strommessungen sendet, die in jeder Phase und zu mehreren Zeitpunkte genommen werden.

6. System nach einem der vorherigen Ansprüche, wobei besagte Sensorfaser (41, 51) eine hoch doppelbrechende sensitive optische Faser (451, 551) umfasst.

7. System nach Anspruch 6, wobei besagte hoch doppelbrechende sensitive optische Faser (451, 551) während der Herstellung verdrillt wunde.

8. System nach einem der vorherigen Anspruche, wobei besagte Verbindung eines Endes der sensitiven optischen Faser (451, 551) mit der passiven optischen Schaltung (581) in der Fabrik hergestellt wird, besagte Verbindung eines Endes der nicht-sensitiven optischen Faser (552) mit der passiven optischen Schaltung (582) in der Fabrik hergestellt wird und besagter Spleiß (E) zwischen den freien Enden der sensitiven optischen Faser (451, 551) und der nicht-sensitiven optischen Faser (552) in der Fabrik hergestellt wird.

9. System nach einem der vorherigen Ansprüche, wobei besagter optischer Stromsensor (40) ausgestaltet ist, um um ein isoliertes Hochspannungskabel herum angebracht zu werden.

10. System nach einem der vorherigen Ansprüche, wobei besagtes Fehlerunterscheidungsgerät (70, 80) ausgestaltet ist, um in einer Umspannstelle des elektrischen Leistungsnetzes angebracht zu werden.

11. System nach einem der vorherigen Ansprüche, welches an wenigstens besagter erster Stelle der gemischten Leitung eine Vielzahl an optischen Stromsensoren (60), die jeweils aus einer Sensorfaser (41, 51, 61), die gewendelt und eingerichtet ist, um ein elektrisches Lcistungsübertragungskabel zu umgeben, dessen Stromintensität zu überwachen ist, und einer passiven optischen Schattung (48, 58 68a, 68b, 68c) ausgebildet sind, und einen Verteilerkasten (62, 82), mit welchem besagte Vielzahl an optischen Stromsensoren (60) mittels dediziertem faseroptischen Kabel (67) verbunden sind, umfasst; wobei besagtes Fehlet-unterscheidungsgerät (70, 80) mit besagtem Verteilerkasten (65, 82) mittels monomodaler optischer Faser (89) verbunden ist.

12. System nach Anspruch 11, wobei besagter Verteilerkasten (62, 82) ausgestaltet ist, um an einem Mast zum Tragen von elektrischen Leistungsübertragungsleitungen angebracht zu werden.

13. System nach einem der Absprüche 11 oder 12, welches Multiplexmittel (68c, 670) umfasst, die eingerichtet sind, um jede Ausgangsfaser (69) jeder passiven Schaltung (68a, 68b, 68c) in ein einziges gebündeltes Signal (67) zu bündeln, welches mit besagtem Verteilerkasten (62) gekoppelt ist.

14. System nach einem der vorherigen Ansprüche, wobei besagtes Fehlerunterscheidungsgerät (70) eine Lichtquelle (72), die eingerichtet ist, um einen Lichtpuls in Richtung der Sensorfaser (41, 51) zu emittieren; eine Vielzahl an Fotodetektoren (73), die eingerichtet sind, um die Antworten zu empfangen, die von den Sensorfasern (41, 51) kommen; und Mittel (74, 71, 75) zum Verarbeiten besagter Antworten und Detektieren von Fehlern auf der elektrischen Leistungsübertragungsleitung, umfasst.

15. System nach Anspruch 14, wobei besagtes Fehlerunterscheidungsgerät (70) zusätzlich eine Vielzahl an Duplexanschlüssen monomodaler optischer Fasern (77) umfasst.

**Revendications**

1. Système optique différentiel destiné à l'identification à distance de défaillances sur une ligne de transmission d'énergie électrique mixte délimitée par une première sous-station électrique et une seconde sous-station électrique, dans lequel ladite ligne mixte comprend au moins une section de ligne aérienne et une section de ligne câblée, le système optique différentiel comprenant :

au moins un premier capteur de courant optique (40) situé au niveau d'un premier point de ladite ligne mixte, qui comprend : une fibre de capteur (41, 51) conçue pour entourer un câble de transmission d'énergie électrique dont l'intensité de courant doit être surveillée, et un circuit optique passif (48, 58),
au moins un second dispositif de mesure du courant indépendant dudit premier capteur de courant optique (40), situé au niveau d'un second point de ladite ligne mixte, et configuré pour effectuer des mesures de l'intensité du courant qui circule dans un câble de transmission d'énergie électrique, et
un dispositif de distinction des défaillances (70, 80) configuré pour traiter les mesures de courant qui proviennent dudit au moins un premier capteur de courant optique (40) et dudit au moins un second dispositif de mesure du courant, et pour détecter les défaillances sur ladite ligne de transmission d'énergie électrique mixte,
le système optique différentiel étant **caractérisé en ce que** ladite fibre de capteur (41) est composée d'une section de fibre optique sensible (451, 551) reliée à une extrémité (581) audit circuit optique passif (48, 58) et d'une section de fibre optique insensible (552) reliée à une extrémité (582) audit circuit optique passif (48, 58), et dans lequel l'extrémité libre de ladite fibre optique sensible (451, 551) est reliée à l'aide d'une épissure (E) à l'extrémité libre de ladite fibre optique insensible (552), de sorte que ladite section de fibre optique sensible (451, 551) agisse comme un élément de mesure de l'intensité du courant à surveiller, et que ladite section de fibre optique insensible (552) agisse comme un moyen de transmission des mesures effectuées audit circuit optique passif (48, 58),
et **en ce que**
ledit dispositif (70, 80) est relié audit capteur de courant optique (40) à l'aide d'une fibre optique monomode (89), ladite fibre optique monomode (89) étant configurée pour l'envoi d'un signal optique et le retour des mesures effectuées par la fibre de capteur (41, 51) vers ledit dispositif de distinction des défaillances (70, 80).

2. Système selon la revendication 1, dans lequel, si ladite ligne mixte est une ligne mixte intermédiaire, ledit au moins un second dispositif de mesure du courant indépendant dudit premier capteur de courant optique (40) est un second capteur de courant optique, qui comprend : une fibre de capteur (41, 51) qui peut être disposée autour d'un câble de transmission d'énergie électrique dont l'intensité de courant doit être surveillée, et un circuit optique passif (48, 58).

3. Système selon la revendication 1, dans lequel, si ladite ligne mixte est une ligne mixte terminale, ledit au moins un second dispositif de mesure du courant indépendant dudit premier capteur de courant optique (40) est un transformateur de courant.

4. Système selon la revendication 3, dans lequel ledit dispositif de distinction des défaillances (70, 80) est situé dans la sous-station électrique la plus proche dudit second dispositif de mesure du courant.

5. Système selon l'une quelconque des revendications précédentes, dans lequel ledit circuit optique passif (48, 58) comprend un premier coupleur bidirectionnel (C3) ; trois seconds coupleurs bidirectionnels (C4, C5, C6) reliés audit premier coupleur bidirectionnel (C3) ; et deux troisièmes coupleurs bidirectionnels (C1, C2) reliés respectivement à l'un des ports de chaque second coupleur bidirectionnel (C4, C5, C6) ; et dans lequel ladite fibre de capteur (41, 51) est reliée au premier coupleur bidirectionnel (C3) en formant une boucle de Sagnac, de sorte que, en réponse à une impulsion de lumière envoyée à la fibre de capteur (41, 51), cette dernière envoie une pluralité de mesures de courant effectuées dans chaque phase et à plusieurs moments différents.

6. Système selon l'une quelconque des revendications précédentes, dans lequel ladite fibre de capteur (41, 51) comprend une fibre optique sensible à biréfringence élevée (451, 551).

7. Système selon la revendication 6, dans lequel ladite fibre optique sensible à biréfringence élevée (451, 551) a été torsadée pendant sa fabrication.

8. Système selon l'une quelconque des revendications précédentes, dans lequel ledit raccordement d'une extrémité de la fibre optique sensible (451, 551) au circuit optique passif (581) est effectué en usine, ledit raccordement d'une extrémité de la fibre optique insensible (552) au circuit optique passif (582) est effectué en usine, et ladite épissure (E) entre les extrémités libres de la fibre optique sensible (451, 551) et de la fibre optique insensible (552) est effectuée en usine.

9. Système selon l'une quelconque des revendications précédentes, dans lequel ledit capteur de courant optique (40) est conçu pour être installé autour d'un câble à haute tension isolé.

10. Système selon l'une quelconque des revendications précédentes, dans lequel ledit dispositif de distinction des défaillances (70, 80) est conçu pour être installé dans une sous-station du réseau d'énergie électrique.

11. Système selon l'une quelconque des revendications précédentes, qui comprend, dans au moins ledit premier point de la ligne mixte, une pluralité de capteurs de courant optiques (60) chacun composés d'une fibre de capteur (41, 51, 61) bobinée et configurée pour entourer un câble de transmission d'énergie électrique dont l'intensité de courant doit être surveillée, et d'un circuit optique passif (48, 58, 68a, 68b, 68c),
et un boîtier de jonction (62, 82) auquel ladite pluralité de capteurs de courant optiques (60) est reliée à l'aide d'un câble à fibre optique dédié (67) ;
dans lequel ledit dispositif de distinction des défaillances (70, 80) est relié audit boîtier de jonction (62, 82) à l'aide d'une fibre optique monomode (89).

12. Système selon la revendication 11, dans lequel ledit boîtier de jonction (62, 82) est conçu pour être installé sur un pylône destiné à portier des lignes de transmission d'énergie électrique.

13. Système selon l'une quelconque des revendications 11 ou 12, qui comprend un moyen de multiplexage (68c, 670) configuré pour multiplexer chaque fibre de sortie (69) de chaque circuit optique passif (68a, 68b, 68c) en un seul signal multiplexé (67) relié audit boîtier de jonction (62).

14. Système selon l'une quelconque des revendications précédentes, dans lequel ledit dispositif de distinction des défaillances (70) comprend une source de lumière (72) configurée pour émettre une impulsion de lumière vers la fibre de capteur (41, 51) ; une pluralité de photodétecteurs (73) configurés pour recevoir les réponses qui proviennent de ladite fibre de capteur (41, 51); et des moyens (74, 71, 75) destinés à traiter lesdites réponses et à détecter les défaillances sur la ligne de transmission d'énergie électrique.

15. Système selon la revendication 14, dans lequel ledit dispositif de distinction des défaillances (70) comprend en outre une pluralité de ports duplex de fibre optique monomode (77).

FIG. 1

# FIG. 2A
(State of the art)

# FIG. 2B
(State of the art)

**FIG. 3**
**(State of the art)**

FIG. 4A

## FIG. 4B

## FIG. 4C

**FIG. 5A**

**FIG. 5B**

**FIG. 6A**

**FIG. 6B**

EP 3 043 189 B1

**FIG. 7**

**FIG. 8A**

**FIG. 8B**

**FIG. 8C**

**FIG. 8D**

$$Idiff = \left| \vec{I}_{S1} + \vec{I}_{S2} \right|$$

$$Ir \to Ir = \frac{\left| \vec{I}_{S1} \right| + \left| \vec{I}_{S2} \right|}{2}$$

$$Ir = \max\left\{ \left| \vec{I}_{S1} \right|, \left| \vec{I}_{S2} \right| \right\}$$

**FIG. 9**

## REFERENCES CITED IN THE DESCRIPTION

### Patent documents cited in the description

- US 20040189997 A1
- US 6611337 B
- WO 2009103126 A1
- WO 2011031945 A1